Europäisches Patentamt

(19) European Patent Office

Office européen des brevets

(11) Publication number: **0 241 155 B1**

(12) **EUROPEAN PATENT SPECIFICATION**

(45) Date of publication of the patent specification:
28.03.90

(21) Application number: **87302241.2**

(22) Date of filing: **17.03.87**

(51) Int. Cl.⁴: **C23C 14/16, C23C 14/14, G11B 5/85, G11B 5/84, G11B 5/66**

(54) **Depositing vanadium underlayer for magnetic films.**

(30) Priority: **22.04.86 US 854621**
**31.03.86 US 846528**

(43) Date of publication of application:
**14.10.87 Bulletin 87/42**

(45) Publication of the grant of the patent:
**28.03.90 Bulletin 90/13**

(84) Designated Contracting States:
**AT BE CH DE FR GB IT LI LU NL SE**

(56) References cited:
**EP-A- 0 053 811**
**EP-A- 0 089 609**
**EP-A- 0 187 169**
**CH-A- 485 867**
**CH-A- 550 862**
**CH-A- 634 605**

**SOVIET INVENTIONS ILLUSTRATED, SECTION CH, week d05, march 11, 1981 DERWENT PUBLICATION LTD., SU-M**
**PATENT ABSTRACTS OF JAPAN, unexamined appl., c field, vol.7, no.281, dez.15, 1983 THE PATENT OFFICE JAPANESE GOVERNMENT, page 127 c 200**

(73) Proprietor: **UNISYS CORPORATION, 1, Burroughs Place, Detroit Michigan 48232(US)**

(72) Inventor: **Lee, Hyung Jai, 5249 War Wagon Court, San Jose, CA 95136(US)**
Inventor: **Baral, Debasis, 818 Teresi Court, 2, San Jose, CA 95117(US)**
Inventor: **Herte, Lawrence, 399 Matadero Avenue, Palo Alto, CA 94306(US)**

(74) Representative: **Kirby, Harold Douglas Benson et al, G.F. Redfern & Company Marlborough Lodge 14 Farncombe Road, Worthing West Sussex BN11 2BT(GB)**

## Description

This concerns underlayers, or substrates, for deposition of magnetic films, especially those like cobalt-nickel films used in magnetic recording; more particularly it concerns methods of depositing vanadium material as such an underlayer.Workers in the magnetic recording arts are aware of the advantages of using thin film media (e.g., as opposed to particulate media); e.g., to achieve high linear recording density. For instance, Co-Ni films make excellent longitudinal recording media.

This relates to the use of vanadium materials as an underlayer for deposition of magnetic thin films, particularly for Co-Ni films as used for advanced magnetic recording.

Thus, it is an object to realize the mentioned results and alleviate the recited problems -- at least in part; and, in particular, to teach deposition of vanadium underlayer structure for deposition of Co-Ni magnetic thin films.These and other features and advantages of the present invention will be appreciated by workers as they become better understood by reference to the following detailed description of the present preferred embodiments which should be considered in conjunction with the accompanying drawings, wherein like reference symbols denote like elements:

FIG. 1 a very schematic section showing underlayer and overlying magnetic film;

FIGS. 2 and 3, plotting variations of coercivity and squareness with "V-underlayer" and with Co-Ni film respectively; and

FIGS. 4A, 4B, representing SEM photomicrographs showing cross-section of .08 um Co-Ni and 0.50 um Co-Ni respectively (both over 0.3 um V).

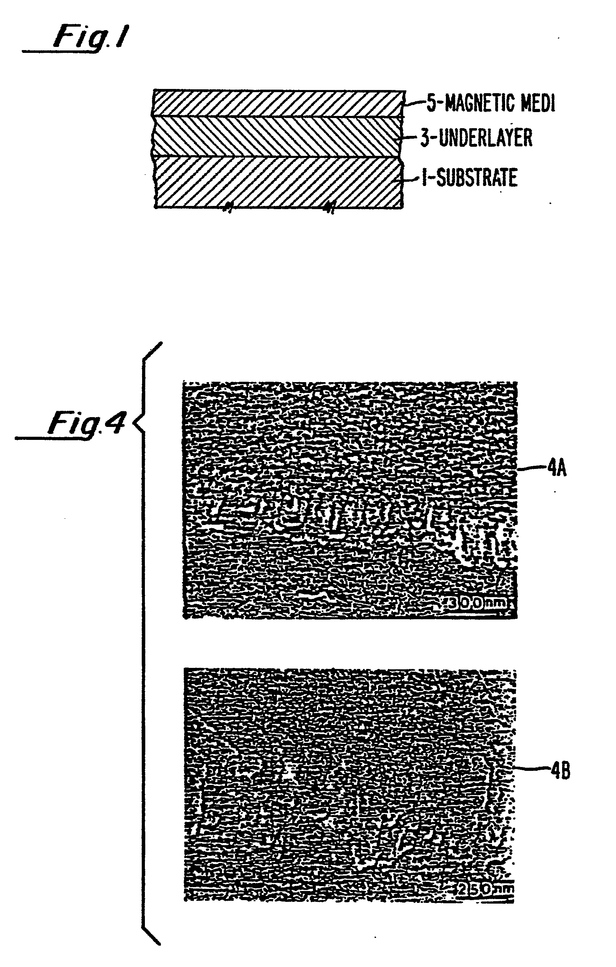

FIG. 1 schematically illustrates a vanadium underlayer 3 constructed according to principles of this invention. This, and other films and materials discussed herein, will generally be understood as constructed and operating as presently known in the art, except where otherwise specified. And, except as otherwise specified, all materials, methods and devices and apparatus herein will be understood as implemented by known expedients according to present good practice.

### --Co-Ni films in general:

Our initial Examples (below) are directed toward Co-Ni films. Sputtered Co-Ni thin films are believed excellent candidates for advanced longitudinal magnetic media [e.g., see R.D. Fisher, MRR '83 International Conference on Magnetic Recording Media, Ferrara, Italy, Sept. 1983; L.F. Herte and A. Lang, Jr., J. Vac. Sci. Tech., 18, No. 2 1981, pp. 153-155; R.D. Fisher, L. Herte, A. Lang, IEEE Trans. Mag., Vol. MAG-17, No. 6, 1981, pp. 3190-3192; and H. Maeda, J. Appl. Phys., 53 (10), 1982, pp. 6941-6945].

It seems that the magnetic properties of relatively thin Co-Ni films are largely dependent on the preferred orientation of the film, and that high coercivity of Co-Ni alloy films can be due to the strong preferred orientation of these films with the c-axis parallel to the film plane. It also seems that changes in film texture affects the magnetic properties of Co-Ni alloy films. However, the correlation between the crystal texture and magnetic properties of Co-Ni thin films is not well established.

We have investigated the effect of crystal texture on magnetic properties of relatively thin "hexagonal close packed" (HCP) Co-Ni films. The films of various thicknesses were sputter deposited on different types of substrates to study the mechanism of Co-Ni film growth. The in-plane coercivity, squareness ratio and M-H hysteresis loop were also studied as a function of thickness of different films as well as their crystal textures.

### --Other approaches:

FIG. 1 will be understood as depicting a thin film longitudinal magnetic recording structure (shown only fragmentarily, in section, and idealized) comprising a substrate 1 (flexible or rigid) on which is placed an underlayer 3 with a thin magnetic film 5 (e.g., for digital recording), superposed on the underlayer 3. Such a magnetic film 5 may be understood as deposited (e.g., sputtered) to a depth of about 0.05-0.5 um (i.e., 500-5000 A°). Underlayer 3 will be assumed as intended to enhance magnetic properties; it will be about 500-10000 A° thick (.05-1 um).

We found that sputtered Co-Ni films (.05-1 um) with no underlayer have a relatively low coercivity, e.g., about 300 Oe (this is undesirably low for high density digital magnetic recording, e.g., 20,000 fc/i or more; also see article by H.J. Lee and D. Baral in IEEE Trans. MAG-21 (5) 1477, Sept. '85).

Some have suggested a sputtered underlayer of chromium for like purposes (see L.F. Herte and A. Lang, J. Vac. Sci. Technol. Vol. 18, No. 2, page 153, 1981); or one of molybdenum (see K.Y. Ahn, K.N. Tu, IBM TDB, Vol. 21, No. 10, 4232, 1979), to achieve high coercivities (i.e., 500 Oe or more).

We believe that for such a sputtered film 5 one should specify an underlayer 3 of prescribed minimum thickness (according to materials involved) to assure desired, reproducible magnetic properties. For instance, because of the relative sensitivity of coercivity of Co-Ni on a Cr thickness, we have found a useful minimum thickness of Cr underlayer to be about 4000 A°.

Now, a reduction in underlayer thickness would be attractive economically (e.g., less running time and material consumption during production). Also, chromium is very susceptible to oxidation and, therefore, requires higher vacuum during deposition. Also, coercivity can vary unduly with chromium underlayer thickness (similar for Mo).

Rather unexpectedly, we find that using vanadium as an underlayer is superior in all the above respects; i.e., less thickness required; little susceptibility to oxidation; and little variance in Hc of overcoating (given certain minimum V thickness).

Thus, as a feature hereof, we propose using vanadium as such an underlayer, especially for sputtered Co-Ni, and especially to enhance coercivity and squareness. We find that, compared with a chromium underlayer, vanadium can be much thinner, much less susceptible to oxidation and makes Hc vary less with underlayer thickness.

For instance, in Ex. I we propose using freshly sputtered vanadium (0.05 to 1.0 µm) as an underlayer material to obtain moderately high coercivity and reasonable squareness in sputtered Co-Ni (0.05 to 0.5 µm) thin magnetic films.

Ex. I: Co-20 Ni over .05 to 1 µm V:

Approximately 80 nm (800 Å) Co-20 Ni is sputtered on vanadium underlayers of various thicknesses (0.05 to 1 µm). The deposition is done at 75 µPa (10 mTorr) Argon pressure using an R.F. diode sputtering (otherwise assume normal processing, e.g., at room temperature).

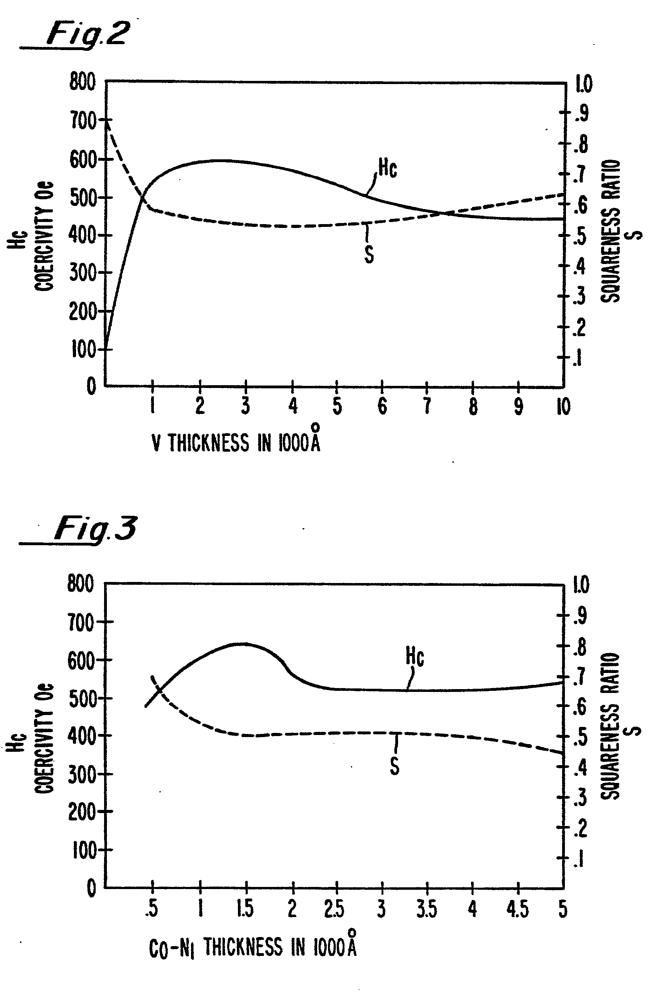

The in-plane magnetic properties are measured by a vibrating sample magnetometer. The variations in coercivity (Hc) and squareness ratio (S) of 80 nm (800 Å) of Co-20 Ni films for various thicknesses of vanadium are shown in Fig. 2.

For V thickness above 100 nm (1000 Å) up to 1000 nm (10k Å), the coercivity is always above 500 Oe (assume 500–600 Oe is min. satisfactory coercivity here). A small maximum in Hc is noticed at a V thickness of about 300 nm (3000 A).

Here, and in Ex. II, we assume that the Co–Ni film derived is a stable "hexagonal close packed"(HCP) structure.

Ex. II: vary thickness of Co-20 Ni:

Ex. I is repeated, but modified to vary Co–Ni thickness, keeping V constant. Thus, Co-20 Ni films in the thickness range .05–.5 µm are sputtered onto an underlayer of 0.3, µm V (3000 Å). Magnetic properties (Hc, S) of the Co-Ni films are plotted in Fig. 3.

Results:

Surprisingly, it is found that the coercivities of such Co-Ni films are in the (presumably desired) range of 600 ± 100 Oe, irrespective of the thickness of the Co-Ni film. This is decidedly different from our experience with Cr underlayers.

The x-ray diffraction of these films do not show any preferred orientation for vanadium and Co-Ni. Typical "fracture cross-sections" of such films are shown in FIG. 4; they indicate the presence of "columnar" (Co-Ni and V) structures.

We believe that the high coercivity obtained in such Co-Ni alloy films using the technique described above is related to a specific microstructure of the Co-Ni films as deposited on vanadium. The higher coercivity is probably due to small ( $<$ 200 A°) crystallites of Co-20Ni with [101$\overline{1}$] or [10$\overline{1}$0] texture which could not be detected with x-ray diffractometer. Probably vanadium has small ($<$ 200 A°) crystallites with [110] orientation which helped Co-20 Ni grow in the above orientation, which could not be measured with x-rays. Therefore, the crystal structure of the V is believed to induce a favorable crystal structure in Co-Ni films.

Such a structure can also be made using other preparation methods such as electro-plating, DC magnetron sputtering, electron beam evaporation, and vapor deposition methods (cf. of V, of Co-Ni, and, preferably, of both).

Variations of Ex. I, II:

Such V underlayers are preferred for all like magnetic thin films, specifically all-Co to Co-40 Ni; and over thickness ranges from 500 to 5000 A°; and contemplating coercivities of from 500-700 Oe and squareness of about 0.6-0.9.

The vanadium laid down should be relatively pure (e.g., above 90%, with no more than 10% other metals, oxide, etc.); should be less than about 1 um thick. V underlayers will also be contemplated for supercoatings of Co alone and alloys of Co and Co-Ni [e.g., Co-Cr, Co-Ni-Cr; and Co-Pt and Co-Ni-Pt]. In some cases a number of V underlayers will be feasible.

We find that many substrates (for V underlayer) seem satisfactory; especially a metal like that of the well known aluminum disk (e.g., polished flat, sometimes with Ni-phosphorous super-plating to harden). In some cases a glass or thermally-stable plastic can suffice.

Further advantages to so using vanadium as an underlayer are:

1. Less minimum thickness of vanadium is needed to obtain similar magnetic properties (e.g., 1000 A° of V vs. 4000 A° Cr);

1A. The thickness of vanadium required to achieve ~600+ Oe coercivity in super-coated Co-Ni is ~1/4 (one fourth) that required using chronium as an underlayer.

2. Thickness insensitivity of vanadium (e.g., vs. magnetic properties; see FIG. 2) indicates one can relax deposition process control parameters; this can be important in light of inherent thickness inhomogeneity with sputter deposition.

2A. Use of vanadium as the underlayer makes process control easier, since variation in the thickness of vanadium above about 1000 A° does not change coercivity of Co-Ni appreciably.

3. Vanadium is a lighter (~17%) material compared with chromium. Also, the required thickness of vanadium for "high coercivity" (e.g., of Co-Ni) is one-fourth that of chromium. This makes for more (bits/gm) recording density of sputtered composite layer when vanadium is used as underlayer.

4. The vanadium film is less sensitive to oxidation during deposition, e.g., vs. chromium.

5. A new underlayer material is taught, ie., vanadium has never been used as an "underlayer" material, such as to achieve high coercivity in Co-Ni or like films.

6. This "Co-Ni on V" structure can give rise to a thin film recording medium whose magnetic properties are more predictable; e.g., being more independent of variations in Co-Ni thickness (FIG. 3) and/or of vanadium thickness (FIG. 2), whereas "Co-Ni on Cr underlayer" structure is relatively sensitive to variations in thickness of Co-Ni and of Cr.

## Variations on Ex. I, II:

Workers will understand that the specific Co–Ni films of Ex. I, II can be varied or supplemented as known in the art while still deriving (at least some of) the advantages of using a vanadium underlayer.

For instance, the desired magnetic properties can be varied, and/or they can be obtained (controlled) by control of deposition parameters (e.g., deposition rate), by adding alloy constituents, by using other atmospheres (e.g., Ar–$N_2$ gas mixture, or by changing the surface temperature of the deposition substrate).

Ex. III–VI below, vary Ex. I in terms of the method of sputtering, the argon pressure, the substrate temperature, and the deposition rate.

### Ex. III: as I except change Ar pressure:

Ex. I is replicated, except that argon pressure is raised to about 225 µPa (30 mTorr).

The result is comparable to that of Ex. I except that the deposited vanadium is more columnar with a morphology (surface texture) that is more sharply defined. This is less desirable for optimum Co–Ni characteristics (e.g., the coercivity will be adversely affected).

Accordingly, we prefer to keep argon pressure "moderate", e.g. below about 150 µPa (20 mTorr); preferably between about 37.5–112 µPa (5–15 mTorr). (If other gas is used, e.g. Ar–$N_2$, we still prefer "below 150 µPa (20mTorr).").

### Ex. IV: as I, use DC magnetron:

Ex. I is replicated except that DC magnetron sputtering replaces the RF diode. No adjustment in process parameters is needed, e.g., pumpdown base pressure, argon pressure, or system geometry.

Result: comparable to that in Ex. I, except for better thickness uniformity and less substrate heating for DC magnetron sputtering.

### Ex. V: as I, but heat substrate:

Ex. I is replicated, but the substrate is heated to about 400°C.

Result: is as Ex. I except that the substrate degrades the magnetic properties of media, e.g., Ni-P plated substrate. Thus, we prefer to keep substrate temperature below about 300°C. Interestingly, this is not true of all metals so sputtered on a metal substrate.

Here, and for all Examples, workers will understand that the vanadium underlayer is to be deposited on a substrate of suitable flatness, adhesion characteristics and other characteristics (e.g., a metal substrate such as highly-polished aluminum is usually preferred to withstand the high temperatures involved). Here, a maximum roughness will be the order of about 4 nm (1 microinch) (variation from mean level surface). At times, such a metal substrate may be pre-coated with a smoothing layer, such as Ni–P or Ni–P–Cu, before final polishing. Substrate polishing or the like will be particularly necessary for such a substrate because the depositions (cf. V, then Co-Ni) are so thin as to closely "conform" to the substrate surface configuration. And, with a Ni-P smoothing layer, heating of the substrate (e.g., while sputtering V, as in Ex. V) should be kept below about 300° C (350-380° C for Ni-P-Cu) lest magnetic properties be degraded.

### Ex. VI: as I but raise deposition rate:

Ex. I is replicated, but the V is sputtered at from 8000-10,000 A°/min.

Result: is like Ex. I, except that the microstructure of media is changed to amorphous phase, which may be undesired. Thus, we prefer to so sputter at a "moderate rate"; e.g., between about 10 to 6,000 A°/min.; preferably 10 to 500 A°/min. with RF diode equipment (100 to 6,000 A°/min. with DC magnetron).

### --In general:

Vanadium, especially as described above, is preferred as an underlayer for ferromagnetic films (like Co-20 Ni) in the thickness range: about 1,000 to 10,000 A° particularly to achieve "higher" HC (e.g., 600 ± 100 Oe or more) and reasonably "good" squareness (e.g., 0.7 ± 0.1).

It will be understood that the preferred embodiments described herein are only exemplary, and that the invention is capable of many modifications and variations in construction, arrangement and use without departing from the spirit of the invention. For example, the means and methods disclosed herein are also applicable to vertical recording systems and the like, as well as to certain thin film heads. Also, the present invention is applicable for providing underlayers and magnetic supercoatings in other forms of recording and/or reproducing systems.

The above examples of possible variations of the present invention are merely illustrative. Accordingly, the present invention is to be considered as including all possible modifications and variations coming within the scope of the invention as defined by the appended claims.

## Claims

1 . A method of fabricating a magnetic structure comprising sputter-depositing between 50 and 1000 nm (500 and 10000 Å) of vanadium containing not more than 10% impurities at a rate of 1 to 600 nm ( 10 to o 6000 Å) per minute onto a suitable flat substrate; this substrate being kept at a temperature less than 300°C; the sputter-medium being kept at a pressure between 37.5 and 150 µPa (5–20 mTorr); and then depositing between 50 and 500 nm (500 and 5 000 Å) of a magnetic cobaltous film onto the vanadium; this film comprising Co or Co–Ni or Co–Cr or Co–Ni–Cr or Co–Re or Co–Pt or Co–Ni–Pt.

2. A method as claimed in Claim 1, wherein the cobaltous film is HCP type adapted for high density magnetic recording of 6000–10000 fc/cm (15–25 thousand fc/i), and sufficient vanadium is so-deposited to optimize the coercivity and squareness of the cobaltous film.

3. A method as claimed in Claim 2 wherein sufficient vanadium is deposited to yield film coercivity of at least 500 Oe and film squareness of at least 0.6.

4. A method as claimed in any of the preceding Claims, wherein the sputter medium is argon.

5. A method as claimed in any of the preceding claims, wherein the cobaltous film comprises Co–Ni, and at least 100 nm (1000 Å) vanadium is sputtered using RF diode or DC magnetron equipment onto the substrate whose roughness does not exceed 4 nm (1 microinch).

6. A method as claimed in Claim 5, wherein the film comprises 50–500 nm (500–5000 A) of sputter-deposited Co-20 Ni.

7. A method as claimed in Claim 6, wherein the vanadium and Co-20 Ni are sputter-deposited with RF diode equipment.

8. A method as claimed in Claim 6, wherein the vanadium and Co-20 Ni are sputter-deposited with DC magnetron equipment.

9. A ferromagnetic structure including a cobaltous film having a thickness between 50 and 500 nm (500 and 5000 Å) and a vanadium underlayer having a uniform thickness between 50 and 1000 nm (500 and 10000 Å).

10. A structure as claimed in Claim 9, wherein the film is a magnetic recording cobaltous film.

11. A structure as claimed in Claim 9 or Claim 10, produced by a method as claimed in any of Claims 1 to 8.

## Patentansprüche

1. Verfahren zur Herstellung eines magnetischen Körpers bei dem eine Schicht von 50 bis 1000 nm (500 bis 10000 Å) aus Vanadium mit nicht mehr als 10% Verunreinigungen bei einer Auftragsrate von 1 bis 600 nm (10 bis 6000 Å) pro Minute auf ein geeignetes flaches Substrat aufgesputtert wird, wobei dieses Substrat auf einer Temperatur von weniger als 300°C und das Sputtermedium auf einen Druck zwischen 37,5 und 150 µPa (5 bis 20 mTorr) gehalten wird; und bei dem dann ein magnetischer kobalthaltiger Film von 50 bis 500 nm (500 bis 5000 Å) auf das Vanadium aufgebracht wird, wobei dieser Film aus Co oder Co–Ni oder Co–Cr oder Co–Ni–Cr oder Co–Re oder Co–Pt oder Co–Ni–Pt besteht.

2. Verfahren nach Anspruch 1, dadurch gekennzeichnet, daß der kobalthaltige Film eine HCP-Type für magnetische Aufzeichnung mit einer hohen Aufzeichnungsdichte von 6000 bis 10000 fc/cm (15 bis 25000 fc/i) ist und daß genügend Vanadium aufgebracht wird, um die Koerzitivkraft und Rechteckförmigkeit des kobalthaltigen Films zu optimieren.

3. Verfahren nach Anspruch 2, dadurch gekennzeichnet, daß genügend Vanadium aufgebracht wird, um eine Film-Koerzitivkraft von mindestens 500 Oe und eine Film-Rechteckförmigkeit von mindestens 0,6 zu erhalten.

4. Verfahren nach einem der vorstehenden Ansprüche, dadurch gekennzeichnet, daß das Sputtermedium Argon ist.

5. Verfahren nach einem der vorstehenden Ansprüche, dadurch gekennzeichnet, daß der kobalthaltige Film Co–Ni enthält und daß mindestens 100 nm (1000 Å) Vanadium durch Benutzung einer HF-Diode oder einer Gleichstrom-Magnetroneinheit auf das Substrat aufgesputtert wird, dessen Rau-higkeit 4 nm (1µ Zoll) nicht überschreitet.

6. Verfahren nach Anspruch 5, dadurch gekennzeichnet, daß der Film 50 bis 500 nm (500–5000 Å) durch Sputtern aufgebrachtes Co-20 Ni enthält.

7. Verfahren nach Anspruch 6, dadurch gekennzeichnet, daß das Vanadium und das Co-20 Ni durch Sputtern mittels einer HF-Diodenanordnung aufgebracht sind.

8. Verfahren nach Anspruch 6, dadurch gekennzeichnet, daß das Vanadium und das Co-20 Ni durch Sputtern mittels einer Gleichstrom-Magnetroneinheit aufgebracht sind.

9. Ferromagnetischer Körper mit einem kobalthaltigen Film einer Stärke von 50 bis 500 nm (500 bis 5000 Å) und einer darunter liegenden Schicht aus Vanadium mit einer gleichmäßigen Schichtstärke von 50 bis 1000 nm (500 bis 10000 Å).

10. Ferromagnetischer Körper nach Anspruch 9, dadurch gekennzeichnet, daß der Film ein kobalthaltiger Film für magnetische Aufzeichnung ist.

11. Ferromagnetischer Körper nach Anspruch 9 oder 10, hergestellt nach einem Verfahren nach einem der Ansprüche 1 bis 8.

## Revendications

1. Procédé de fabrication d'une structure magnétique comprenant une couche de vanadium déposée par pulvérisation ayant une épaisseur comprise entre 50 et 1000 nm (500 et 10000 Å) et ne contenant pas plus de 10% d'impuretés, le dépôt étant fait à une vitesse de 1–600 nm (10–6000 Å) par minute sur un support plat adéquat; ce support est maintenu à une température inférieure à 300°C; le milieu de pulvérisation est maintenu à une pression comprise entre 37,5 et 150 µPa (5–20 mTorr) ; puis, on dépose un film magnétique à base de cobalt d'une épaisseur de 50–500 nm (500–5000 Å) sur le vanadium, ce film étant formé de Co, ou Co–Ni, ou Co–Cr, ou Co–Ni–Cr ou Co–Re ou Co–Pt ou Co–Ni–Pt.

2. Procédé selon la revendication 1, caractérisé en ce que le film de cobalt est du type HCP destiné à un enregistrement magnétique de forte densité de 6000–10000 fc/cm (15–25 milles fc/i), et on dépose suffisamment de vanadium pour optimiser la force coercitive et la forme rectangulaire du film à base de cobalt.

3. Procédé selon la revendication 2, caractérisé en ce qu'on dépose suffisamment de vanadium pour donner au film une force coercitive d'au moins 500 Oe et une forme rectangulaire au moins égale à 0,6.

4. Procédé selon l'une quelconque des revendications précédentes, caractérisé en ce que le milieu de pulvérisation est de l'argon.

5. Procédé selon l'une des revendications précédentes, caractérisé en ce que le film à base de cobalt est du Co–Ni, et on pulvérise au moins 100 nm (1000 Å) de vanadium à l'aide d'une diode RF ou d'un magnétron à courant continu sur le support dont la rugosité ne dépasse pas 4 nm (1 microinch).

6. Procédé selon la revendication 5, caractérisé en ce que le film se compose d'un dépôt par pulvérisation de Co-20 Ni d'une épaisseur de 50–500 nm (500–5000 Å).

7. Procédé selon la revendication 6, caractérisé en ce que le vanadium et l'alliage Co-20 Ni sont déposés par pulvérisation à l'aide d'un équipement à diode RF.

8. Procédé selon la revendication 6, caractérisé en ce que le vanadium et l'alliage Co-20 Ni sont déposés par pulvérisation à l'aide d'un équipement à magnétron à courant continu.

9. Structure ferromagnétique contenant un film de cobalt ayant une épaisseur comprise entre 50 et 500 nm (500 et 5000 Å) et une base de vanadium d'une épaisseur uniforme comprise entre 50 et 1000 nm (500 et 10000 Å).

10. Structure selon la revendication 9, caractérisée en ce que le film est un film à base de cobalt pour l'enregistrement magnétique.

11. Structure selon la revendication 9 ou la revendication 10 obtenue par le procédé revendiqué selon l'une quelconque des revendications 1 à 8.

## _Fig.1_

5-MAGNETIC MEDI

3-UNDERLAYER

1-SUBSTRATE

## _Fig.4_

4A

300nm

4B

250nm

_Fig.2_

_Fig.3_